# EUROPEAN PATENT APPLICATION

(11) **EP 3 951 888 A1**
(43) Date of publication of application: **09.02.2022**
(21) Application number: 21749524.1
(22) Date of filing: 03.03.2021
(51) Int. Cl.: H01L 29/78

(54) **NORMALLY-OFF DEVICE AND MANUFACTURING METHOD THEREFOR**

(30) Priority: 24.06.2020 CN 202021204318 U
(71) Applicant: Guangdong Zhineng Technology Co., Ltd., Guangzhou, Guangdong 510700 (CN)
(72) Inventor: LI, Zilan, Huangpu District Guangzhou, Guangdong 510700 (CN)
(74) Representative: Loyer & Abello
(86) International application number: PCT/CN2021/078958
(87) International publication number: WO 2021/258770

(57) **Abstract**

The present disclosure relates to the technical field of semiconductors, and provides a normally-closed device and a fabrication method thereof. The normally-closed device comprises a substrate; an epitaxial layer connected to the substrate, wherein the epitaxial layer comprises a first P-type nitride layer and a modified layer, the modified layer is located on two sides of the first P-type nitride layer, the modified layer is formed by modifying a second P-type nitride layer in a preset region, and the first P-type nitride layer and the second P-type nitride layer are formed by epitaxially growing synchronously; a barrier layer connected to the first P-type nitride layer and the modified layer; and a gate electrode connected to the barrier layer, and a source electrode and a drain electrode connected to the modified layer. As it is easier to realize the manner of performing modification in some regions, it can be more conveniently realized that an effective P-type and desired device structure only exist in some regions, and meanwhile, the normally-closed device provided in the present disclosure further has the effects of a higher threshold voltage and lower gate current and drain current.

## Description

### Cross-reference to Related Application

The present disclosure claims the priority to the Chinese patent application with the filing No. 202021204318.9, filed on June 24, 2020 with the Chinese Patent Office, and entitled "Normally-closed Device", the contents of which are incorporated by reference herein in entirety.

### Technical Field

The present disclosure relates to the technical field of semiconductors, in particular, to a normally-closed device and a fabrication method thereof.

### Background Art

Currently, the process of fabricating a normally-closed device is generally realized by fabricating a P-type nitride semiconductor gate electrode on a barrier layer. Due to the poor insulation performance of the barrier layer, the occurrence of a large gate current is easily caused. Meanwhile, due to separation of the barrier layer, the gate electrode is relatively far from a channel, which is not favorable for obtaining a relatively high threshold voltage.

In summary, there is a problem in the prior art that the normally-closed device has relatively low threshold voltage and relatively large gate current and drain current.

### Summary

The present disclosure provides a normally-closed device and a fabrication method thereof, so as to solve the problems that the normally-closed device has relatively low threshold voltage and relatively large gate current and drain current.

The present disclosure may adopt the following technical solutions to solve the above problems.

In one aspect, the present disclosure provides a normally-closed device, wherein the normally-closed device includes:
a substrate;
an epitaxial layer connected to the substrate, wherein the epitaxial layer includes a first P-type nitride layer and a modified layer, the modified layer is located on two sides of the first P-type nitride layer, the modified layer is formed by modifying a second P-type nitride layer in a preset region, and the first P-type nitride layer and the second P-type nitride layer are formed by epitaxially growing synchronously;
a barrier layer connected to the first P-type nitride layer and the modified layer; and
a gate electrode connected to the barrier layer, and a source electrode and a drain electrode connected to the modified layer.

Optionally, height of the modified layer located in a source electrode region and a region between the source electrode and the drain electrode is less than that of the first P-type nitride layer, and the modified layer located in the source electrode region and a region between the source electrode and the drain electrode is formed by partially modifying the second P-type nitride layer, so that the modified layer is connected to the second P-type nitride layer and the barrier layer, respectively; and
the normally-closed device further includes a body electrode connected to the second P-type nitride layer and the source electrode, respectively.

Optionally, a doping concentration of the second P-type nitride layer is variable in an epitaxial growth direction.

Optionally, the doping concentration of the second P-type nitride layer is decreased in the epitaxial growth direction.

Optionally, the doping concentration of the second P-type nitride layer is decreased first and then increased in the epitaxial growth direction.

Optionally, the normally-closed device includes a mounting region, the mounting region penetrates through the barrier layer and the modified layer located in the source electrode region, and the body electrode is provided in the mounting region.

Optionally, the normally-closed device further includes an insulating layer located between the gate electrode and the barrier layer.

Optionally, the normally-closed device further includes a channel layer, one side of the channel layer is connected to the first P-type nitride layer and the modified layer respectively, and the other side of the channel layer is connected to the barrier layer, the source electrode, and the drain electrode.

In another aspect, the present disclosure further provides a fabrication method of a normally-closed device, wherein the method includes:
providing a substrate;
fabricating an epitaxial layer in a growth surface of the substrate, wherein the epitaxial layer includes a first P-type nitride layer and a second P-type nitride layer, the second P-type nitride layer is located on two sides of the first P-type nitride layer, and the first P-type nitride layer and the second P-type nitride layer are formed by epitaxially growing synchronously;
modifying the second P-type nitride layer so as to form a modified layer on two sides of the first P-type nitride layer;
fabricating a barrier layer along a side of the first P-type nitride layer and a side of the modified layer, with the two sides away from the substrate; and
fabricating a gate electrode, a source electrode, and a drain electrode.

Optionally, the step of modifying the second P-type nitride layer so as to form a modified layer on two sides of the first P-type nitride layer includes:
fabricating a mask along a surface of the first P-type nitride layer;
modifying the second P-type nitride layer in a source electrode region and a region between the gate electrode and the source electrode in a manner of ion implantation, until the second P-type nitride layer is completely modified; and
removing the mask.

Optionally, heat treatment is performed after the step of removing a mask.

Optionally, a channel layer is epitaxially grown before fabricating the barrier layer.

Optionally, an insulating layer is formed between the gate electrode and the barrier layer.

Optionally, the step of modifying the second P-type nitride layer in a source electrode region and a region between the gate electrode and the source electrode in a manner of ion implantation includes:
implanting Si, Ge, N or Ar into the second P-type nitride layer in a manner of ion implantation.

Optionally, the step of modifying the second P-type nitride layer so as to form a modified layer on two sides of the first P-type nitride layer includes:
fabricating a mask along a surface of the first P-type nitride layer;
partially modifying the second P-type nitride layer in a manner of ion implantation;
modifying the second P-type nitride layer located in a drain electrode region and a region between the gate electrode and the drain electrode in a manner of ion implantation, until the second P-type nitride layer located in the drain electrode region and the region between the gate electrode and the drain electrode is completely modified; and
removing the mask.

Optionally, prior to the step of modifying the second P-type nitride layer located in a drain electrode region and a region between the gate electrode and the drain electrode in a manner of ion implantation until the second P-type nitride layer located in the drain electrode region and the region between the gate electrode and the drain electrode is completely modified, the fabrication method further includes:
removing the mask, and meanwhile fabricating a new mask so as to cover the gate electrode region, the region between the gate electrode and the source electrode, and the source electrode region.

After the step of fabricating a gate electrode, a source electrode, and a drain electrode, the method further includes:
fabricating a body electrode, wherein the body electrode is connected to the second P-type nitride layer and the source electrode, respectively.

Optionally, the step of partially modifying the second P-type nitride layer in a manner of ion implantation includes:
implanting the ions into the second P-type nitride layer according to a first energy and dose; and
the step of modifying the second P-type nitride layer located in a drain electrode region in a manner of ion implantation until the second P-type nitride layer located in the drain electrode region is completely modified includes:
   implanting the ions into the second P-type nitride layer according to a second energy and dose, wherein the first energy and dose are less than the second energy and dose.

In order to make the above objectives, features, and advantages of the present disclosure more obvious and understandable, detailed description is given below with reference to accompanying drawings.

### Brief Description of Drawings

In order to more clearly illustrate technical solutions of the present disclosure, accompanying drawings which need to be used therein will be introduced briefly below, and it should be understood that the accompanying drawings below merely show some embodiments of the present disclosure, therefore, they should not be considered as limitation on the scope, and those ordinarily skilled in the art still could obtain other relevant drawings according to these accompanying drawings, without using any creative efforts.
FIG. 1 is a sectional diagram of a normally-closed device provided in the present disclosure.
FIG. 2 is a sectional diagram of an optional structure of the normally-closed device provided in the present disclosure.
FIG. 3 is a sectional diagram of an optional structure of the normally-closed device provided in the present disclosure.
FIG. 4 is a sectional diagram of an optional structure of the normally-closed device provided in the present disclosure.
FIG. 5 is a flow chart of a fabrication method of the normally-closed device provided in the present disclosure.
FIG. 6 is a flow chart of optional implementation steps of S106 in FIG. 2 provided in the present disclosure.
FIG. 7 is a sectional diagram of an optional structure of the normally-closed device provided in the present disclosure.
FIG. 8 is a flow chart of the fabrication method of an optional structure of the normally-closed device provided in the present disclosure.
FIG. 9 is a flow chart of optional implementation steps of S206 in FIG. 5 provided in the present disclosure.

In the drawings: 100-normally-closed device; 110-substrate; 120-buffer layer; 130-first P-type nitride layer; 140-modified layer; 150-channel layer; 160-barrier layer; 170-passivation layer; 180-body electrode.

### Detailed Description of Embodiments

In order to make objectives, technical solutions, and advantages of the present disclosure clearer, the technical solutions in the present disclosure will be described clearly and completely below in conjunction with accompanying drawings in the present disclosure, and apparently, the embodiments described are some but not all embodiments of the present disclosure. Generally, components in the present disclosure, as described and shown in the accompanying drawings herein, may be arranged and designed in various different configurations.

Therefore, the detailed description below of the embodiments of the present disclosure provided in the accompanying drawings is not intended to limit the scope of the present disclosure claimed, but merely illustrates chosen embodiments of the present disclosure. All of other embodiments obtained by those ordinarily skilled in the art based on the embodiments in the present disclosure without using creative efforts shall fall within the scope of protection of the present disclosure.

It should be noted that similar reference signs and letters represent similar items in the following accompanying drawings, therefore, once a certain item is defined in one accompanying drawing, it is not needed to be further defined or explained in subsequent accompanying drawings. Meanwhile, in the description of the present disclosure, terms such as "first" and "second" are merely for distinctive description, but should not be construed as indicating or implying importance in relativity.

It should be indicated that in the present text, relational terms such as first and second are merely for distinguishing one entity or operation from another entity or operation, while it is not necessarily required or implied that these entities or operations have any such practical relation or order. Moreover, terms "including", "containing" or any other variations thereof are intended to be non-exclusive, thus a process, method, article or device including a series of elements not only include those elements, but also include other elements that are not listed definitely, or further include elements inherent to such process, method, article or device. Without more restrictions, an element defined with wordings "including a..." does not exclude presence of other same elements in the process, method, article or device including said element.

In the description of the present disclosure, it should be indicated that orientation or positional relationships indicated by terms such as "upper", "lower", "inner", and "outer" are based on orientation or positional relationships as shown in the drawings, or orientation or positional relationships of a product of the present disclosure when being conventionally placed in use, merely for facilitating describing the present disclosure and simplifying the description, rather than indicating or suggesting that related devices or elements have to be in the specific orientation or configured and operated in a specific orientation, therefore, they should not be construed as limiting the present disclosure.

In the description of the present disclosure, it should be further illustrated that, unless otherwise specifically regulated and defined, the terms "set" and "connect" should be understood in a broad sense, for example, connection may be fixed connection, detachable connection, or integrated connection; it may be mechanical connection or electrical connection; it may be direct joining or indirect joining through an intermediary, and it also may be inner communication between two elements. For those ordinarily skilled in the art, specific meanings of the above-mentioned terms in the present disclosure could be understood according to specific circumstances.

Optional embodiments of the present disclosure are described in detail below in combination with the accompanying drawings. The following features may be combined with each other without conflict.

As described in the Background Art, currently, the process of fabricating a normally-closed device is generally realized by fabricating a P-type nitride semiconductor gate electrode on a barrier layer. Due to the poor insulation performance of the barrier layer, the occurrence of a large gate current is easily caused. Meanwhile, due to the separation of the barrier layer, the gate electrode is relatively far from a channel, which is not favorable for obtaining a high threshold voltage.

In view of this, the present disclosure provides a normally-closed device, which makes the process able to be easily implemented by modifying a P-type nitride layer in some regions into a modified layer, and meanwhile increases a threshold voltage of the normally-closed device and reduces a gate current and a drain current of the normally-closed device.

Hereinafter, the normally-closed device provided in the present disclosure is exemplarily described.

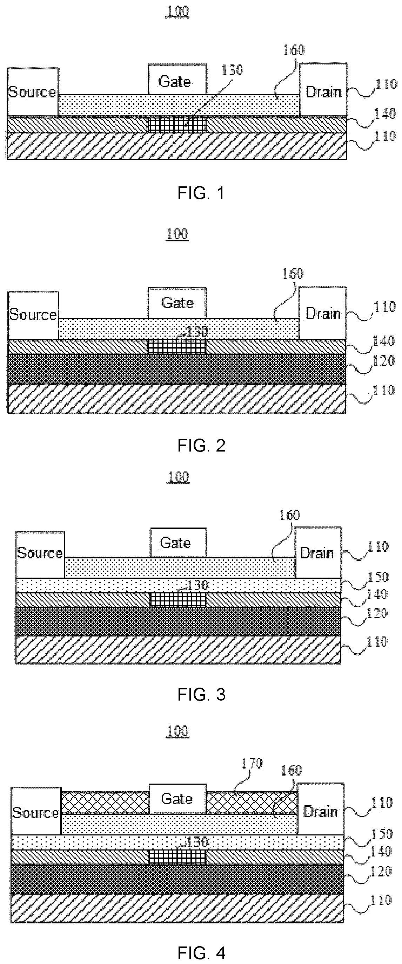

Referring to FIG. 1, as an optional implementation, a normally-closed device 100 includes a substrate 110, an epitaxial layer, a barrier layer 160, and an electrode. In the above, the epitaxial layer includes a first P-type nitride layer 130 and a modified layer 140, and the modified layer 140 is located on two sides of the first P-type nitride layer 130. In the above, the modified layer 140 provided in the present disclosure is formed by modifying a second P-type nitride layer in a preset region, and the first P-type nitride layer 130 and the second P-type nitride layer are formed by epitaxially growing synchronously. In addition, the first P-type nitride layer 130 and the modified layer 140 are located in a same layer.

In the above, the present disclosure does not define the material of the substrate 110, for example, the substrate 110 may be a sapphire substrate 110, a silicon substrate 110, or the like.

Optionally, as shown in FIG. 2, the epitaxial layer in the present disclosure may further include a buffer layer 120. In a fabrication process, first, the buffer layer 120 is grown along a growth surface of the substrate 110, and then the P-type nitride layer is grown on a surface of the buffer layer 120. Optionally, it is also possible that the buffer layer is not included, that is, the P-type nitride layer may be directly grown along the growth surface of the substrate 110.

In the above, the buffer layer 120 in the present disclosure may be a GaN layer, the P-type nitride layer may be a P-type GaN layer, and certainly, other materials also may be possible, for example, a P-type AIGaN layer. Moreover, for convenience of description, the P-type nitride layer provided in the present disclosure may be divided into a first P-type nitride layer 130 and a second P-type nitride layer, wherein the first P-type nitride layer 130 is located in a gate electrode region, the second P-type nitride layer is located in a source electrode region, a region between a gate electrode and a source electrode, a drain electrode region, and a region between the gate electrode and a drain electrode, furthermore, the second P-type nitride layer is located on two sides of the first P-type nitride layer 130.

It may be understood that the first P-type nitride layer 130 and the second P-type nitride layer are actually grown simultaneously, therefore, they have the same doping concentration. Moreover, as an implementation, the first P-type nitride layer 130 and the second P-type nitride layer also have the same height.

Meanwhile, the modification in the present disclosure refers to changing the activity of the second P-type nitride layer, that is, changing the active P-type GaN to be of an N-type or to be in a high resistance state or an insulating type. As an implementation, the property of the second P-type nitride layer may be changed in a manner of ion implantation, for example, N-type impurities such as Si and Ge may be implanted; or the P-type GaN may also be changed to be in a high resistance state or an insulating state by ion implantation, and optional implanted impurities include N, Ar, and the like.

It may be understood that, the barrier layer 160 is continuously grown on the basis of the above structure, at this time, as the second P-type nitride layer has been modified, the P-type nitride layer in contact with the barrier layer 160 is only the first P-type nitride layer 130. Then, the gate electrode is fabricated on the barrier layer 160, and the barrier layer 160 on the two sides is etched until the modified layer 140 on two sides is exposed, and then the source electrode and the drain electrode are respectively fabricated. In the above, a material of the barrier layer 160 provided in the present disclosure may be AlGaN, AlInN or AlInGaN.

It should be noted that, the situation that the P-type nitride layer depletes two-dimensional electron gas will not occur in the modified region, thus maintaining a good transport property. Meanwhile, as the first P-type nitride layer 130 is formed in a manner of ion implantation, a crystal structure is easily damaged, therefore, in the present disclosure, the first P-type nitride layer 130 is realized by a material growth method, which does not easily cause damage to the crystal structure. Moreover, it is easier to modify the P-type nitride layer in some regions to an N-type or an insulating type by a method of performing doping by ion implantation of N-type impurities, so that it is possible to realize that an effective P-type nitride layer and a desired device structure only exist in some regions.

Meanwhile, by means of the above arrangement, on the one hand, the two-dimensional electron gas will not be depleted partially or completely, therefore on-resistance of the device will not be increased, and on the other hand, the first P-type nitride layer 130 can also be far away from the drain electrode, so that a breakdown voltage of the device is higher.

As an optional implementation, in order to reduce scattering effect and other effects of the first P-type nitride layer 130 or implanted impurities, and improve mobility of channel electrons, as shown in FIG. 3, the normally-closed device 100 provided in the present disclosure further includes a channel layer 150, wherein one side of the channel layer 150 is connected to the first P-type nitride and the modified layer 140, and the other side of the channel layer 150 is connected to the barrier layer 160, the source electrode, and the drain electrode. In the present disclosure, the gate electrode will not be far from the channel due to the spacing/separation of the barrier layer, and therefore it is more advantageous to obtain a higher threshold voltage.

Moreover, in order to make the device more stable, as shown in FIG. 4, a passivation layer 170 may also be formed on the barrier layer 160. In order to reduce the gate current and the drain current, an insulating layer (not shown) located between the gate electrode and the barrier layer 160 further may be formed.

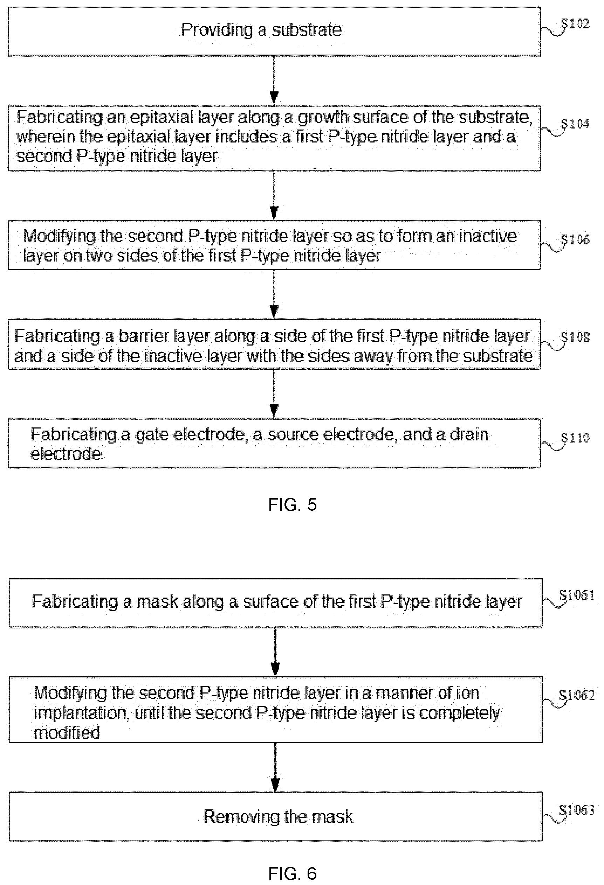

Based on this structure, the present disclosure provides a fabrication method of a normally-closed device, and as shown in FIG. 5, the method includes:
S102, providing a substrate;
S104, fabricating an epitaxial layer along a growth surface of the substrate, wherein the epitaxial layer includes a first P-type nitride layer and a second P-type nitride layer, the second P-type nitride layer is located on two sides of the first P-type nitride layer, and the first P-type nitride layer and the second P-type nitride layer are located on a same plane;
S106, modifying the second P-type nitride layer so as to form a modified layer on two sides of the first P-type nitride layer;
S108, fabricating a barrier layer along a side of the first P-type nitride layer and a side of the modified layer, with the sides away from the substrate; and
S110, fabricating a gate electrode, a source electrode, and a drain electrode.

Optionally, the fabricating the epitaxial layer along the growth surface of the substrate in S104 may include:
S1041, growing a buffer layer along the growth surface of the substrate; and
S1042, growing the epitaxial layer on a surface of the buffer layer.

Optionally, as shown in FIG. 6, S106 may include:
S1061, fabricating a mask along a surface of the first P-type nitride layer;
S1062, modifying the second P-type nitride layer in a manner of ion implantation, until the second P-type nitride layer is completely modified; and
S1063, removing the mask.

Certainly, in order to reduce the ion implantation damage, heat treatment or the like also may be performed after removing the mask.

Moreover, S1062 actually may be a step of implanting Si, Ge, N or Ar into the second P-type nitride layer in a manner of ion implantation, wherein when N-type impurities such as Si and Ge are implanted, the second P-type nitride layer may be modified to be of N-type, and when impurities such as N and Ar are implanted, the second P-type nitride layer may be modified to be in a high resistance state or an insulating state.

Optionally, a channel layer also may be epitaxially grown first before the barrier layer is formed, so as to reduce scattering effect and other effects caused by the first P-type nitride layer or implanted impurities, and improve the mobility of the electrons in the channel. Meanwhile, in order to make the device more stable, a passivation layer may also be formed on the barrier layer. In order to reduce the gate current and the drain current, an insulating layer further may be formed between the gate electrode and the barrier layer.

In the above structure, as only the first P-type nitride layer 130 exists and the first P-type nitride layer 130 in this region is not connected to an external electrode, the threshold voltage of the device may be caused unstable.

In view of this, in order to make the threshold voltage of the device more stable, the present disclosure further provides another structure of the normally-closed device 100. Hereinafter, only differences from the above structure are described, while reference is made to the above contents for similarities.

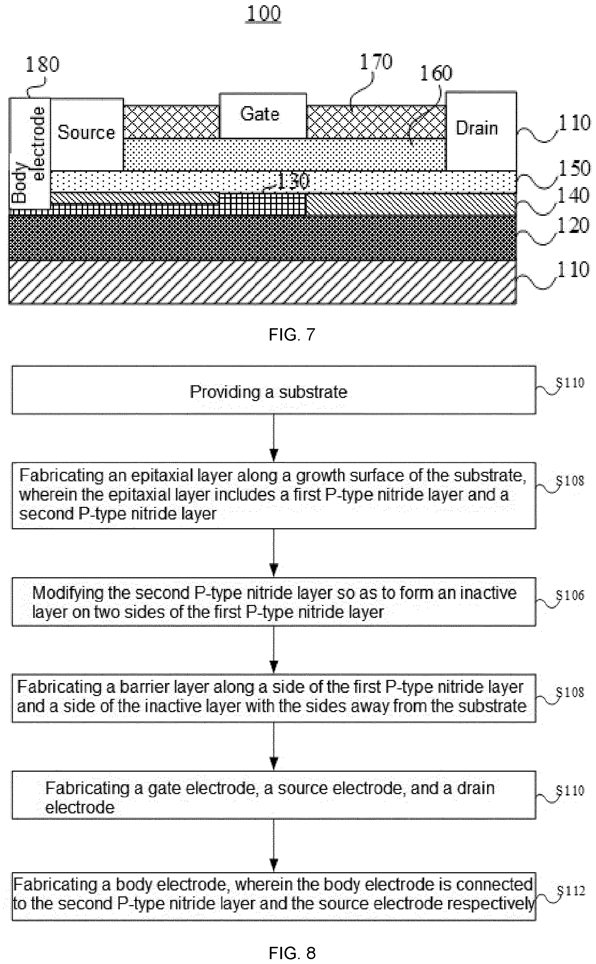

Referring to FIG. 7, as an implementation, the modified layer 140 located in the drain electrode region and a region between the gate electrode and the drain electrode has the same height as the first P-type nitride layer 130, the height of the modified layer 140 located in the source electrode region and a region between the gate electrode and the source electrode is less than that of the first P-type nitride layer 130, and the modified layer 140 located in the source electrode region and the region between the gate electrode and the source electrode is formed by partially modifying the second P-type nitride layer, so that the modified layer 140 is connected to the second P-type nitride layer and the barrier layer 160, respectively. Moreover, the normally-closed device 100 further includes a body electrode 180, and the body electrode 180 is connected to the second P-type nitride layer and the source electrode, respectively.

It may be understood that this structure retains a part of the second P-type nitride layer in the source electrode region and the region between the gate electrode and the source electrode, and only an upper portion of the second P-type nitride layer is modified, thus, through a lower portion of the second P-type nitride layer, the second P-type nitride layer may be electrically connected to the first P-type nitride layer 130 and the potential of the second P-type nitride layer is controlled. In a practical fabrication process, the mask may be fabricated first in the gate electrode region, and then the second P-type nitride layer on two sides is modified. It should be noted that energy and dose of the ion implantation this time are relatively low, therefore only the property of an upper layer is changed, while the lower second P-type nitride layer is still an active layer.

Then, the mask is removed, and meanwhile a new mask is fabricated, so as to cover the gate electrode region, the region between the gate electrode and the source electrode, and the source electrode region, and ions are implanted at high energy and high dose into the drain electrode region and the region between the gate electrode and the drain electrode, so that the second P-type nitride layer in the drain electrode region and the region between the gate electrode and the drain electrode is completely modified to be of an N-type or an insulating type. Finally, the mask is removed.

Optionally, after the electrode has been fabricated, the source electrode region further may be etched, so as to form a mounting region, wherein the mounting region penetrates through the barrier layer 160 and the modified layer 140 located in the source electrode region, and the body electrode 180 is provided in the mounting region.

Optionally, the second P-type nitride layer in the drain electrode region and the region between the gate electrode and the drain electrode may also be treated similarly. That is, the second P-type nitride layer in the drain electrode region and the region between the gate electrode and the drain electrode is partially modified, so that the modified layer located in the drain electrode region and the region between the gate electrode and the drain electrode is connected to the second P-type nitride layer and the barrier layer 160, respectively.

Moreover, in order to make the modification effect and the contact effect with the body electrode better, the doping concentration of the second P-type nitride layer provided in the present disclosure is variable in the epitaxial growth direction. For example, optionally, the doping concentration of the second P-type nitride layer is decreased in the epitaxial growth direction, that is, in the second P-type nitride layer, the doping concentration of a side close to the buffer layer is relatively high, and the doping concentration of a side away from the buffer layer is relatively low, then on this basis, the mounting region may be directly extended to the high concentration region, so that good ohmic contact is formed between the body electrode and the second P-type nitride layer. In addition, optionally, the doping concentration of the second P-type nitride layer is decreased first and then increased in the epitaxial growth direction. That is, the second P-type nitride layer has a relatively high doping concentration on the side thereof close to the buffer layer, a relatively low doping concentration in an intermediate region thereof, and also a relatively high doping concentration on the side thereof away from the buffer layer. In this arrangement manner, the mounting region may be extended to the high concentration region close to the buffer layer when the mounting region is fabricated, so as to form a good ohmic contact between the body electrode and the second P-type nitride layer. Meanwhile, as a high concentration doping mode is adopted when modifying the upper portion of the second P-type nitride layer, the unmodified P-type nitride region below the gate electrode has a relatively high doping concentration, so that a relatively high threshold voltage may be obtained.

Besides, the present disclosure further provides a fabrication method of a normally-closed device in the above structure, and as shown in FIG. 8, the method includes:
S202, providing a substrate;
S204, fabricating an epitaxial layer in a growth surface of the substrate, wherein the epitaxial layer includes a first P-type nitride layer and a second P-type nitride layer, the second P-type nitride layer is located on two sides of the first P-type nitride layer, and the first P-type nitride layer and the second P-type nitride layer are formed by epitaxially growing synchronously;
S206, modifying the second P-type nitride layer so as to form a modified layer on two sides of the first P-type nitride layer;
S208, fabricating a barrier layer along a side of the first P-type nitride layer and a side of the modified layer with the sides away from the substrate;
S210, fabricating a gate electrode, a source electrode, and a drain electrode; and
S212, fabricating a body electrode, wherein the body electrode is connected to the second P-type nitride layer and the source electrode, respectively.

Optionally, the fabricating the epitaxial layer along the growth surface of the substrate in S204 may include:
S2041, growing a buffer layer along the growth surface of the substrate; and
S1042, growing the epitaxial layer on a surface of the buffer layer.

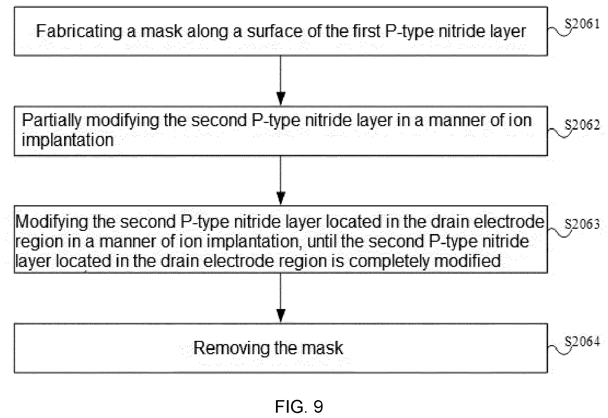

Optionally, as shown in FIG. 9, S206 may include:
S2061, fabricating a mask along a surface of the first P-type nitride layer;
S2062, partially modifying the second P-type nitride layer in the source electrode region and the region between the gate electrode and the source electrode in a manner of ion implantation;
S2063, modifying the second P-type nitride layer located in the drain electrode region and the region between the gate electrode and the drain electrode in a manner of ion implantation, until the second P-type nitride layer located in the drain electrode region and the region between the gate electrode and the drain electrode is completely modified; and
S2064, removing the mask.

Optionally, in S2062 and S2063, ions are implanted into the second P-type nitride layer with different energies and doses, respectively.

Optionally, the energy and dose adopted in S2063 are made greater than those adopted in S2062.

Optionally, before S2063, the mask is removed, and meanwhile a new mask is fabricated to cover the gate electrode region, the region between the gate electrode and the source electrode, and the source electrode region.

To sum up, the present disclosure has the following beneficial effects.

The present disclosure provides a normally-closed device, wherein the normally-closed device includes a substrate; an epitaxial layer connected to a substrate, wherein the epitaxial layer includes a first P-type nitride layer and a modified layer, the modified layer is located on two sides of the first P-type nitride layer, the modified layer is formed by modifying a second P-type nitride layer in a preset region, and the first P-type nitride layer and the second P-type nitride layer are formed by epitaxially growing synchronously; a barrier layer connected to the first P-type nitride layer and the modified layer; a gate electrode connected to the barrier layer, and a source electrode and a drain electrode connected to the modified layer. As it is easier to realize the manner of performing modification in some regions, it can be more conveniently realized that an effective P-type and desired device structure only exist in some regions.

The above-mentioned are merely preferred embodiments of the present disclosure and not used to limit the present disclosure. For one skilled in the art, various modifications and changes may be made to the present disclosure. Any modifications, equivalent substitutions, improvements and so on, within the spirit and principle of the present disclosure, should be covered within the scope of protection of the present disclosure.

For one skilled in the art, obviously, the present disclosure is not limited to details of the above exemplary embodiments, and without departing from the spirit or basic features of the present disclosure, the present disclosure could be implemented in other specific forms. Therefore, no matter from which point of view, the embodiments should be regarded as exemplary but non-limiting, the scope of the present disclosure is defined by the appended claims rather than the above description, therefore all changes falling within the meaning and scope of equivalents of the claims are intended to be covered within the present disclosure. Any reference signs in the claims should not be regarded as limiting the claims involved.

### Industrial Applicability

For the normally-closed device provided in the present disclosure, by adopting the manner of performing modification in some regions, it can be more conveniently realized that an effective P-type and desired device structure only exist in some regions.

## Claims

1. A normally-closed device, wherein the normally-closed device comprises:
a substrate;
an epitaxial layer connected to the substrate, wherein the epitaxial layer comprises a first P-type nitride layer and a modified layer, the modified layer is located on two sides of the first P-type nitride layer, the modified layer is formed by modifying a second P-type nitride layer in a preset region, and the first P-type nitride layer and the second P-type nitride layer are formed by epitaxially growing synchronously;
a barrier layer connected to the first P-type nitride layer and the modified layer; and
a gate electrode connected to the barrier layer, and a source electrode and a drain electrode connected to the modified layer.

2. The normally-closed device according to claim 1, wherein the normally-closed device further comprises a buffer layer located between the substrate and the epitaxial layer.

3. The normally-closed device according to claim 1 or 2, wherein a height of the modified layer located in a source electrode region and a region between the source electrode and the drain electrode is less than a height of the first P-type nitride layer, and the modified layer located in the source electrode region and the region between the source electrode and the drain electrode is formed by partially modifying the second P-type nitride layer, so that the modified layer is connected to the second P-type nitride layer and the barrier layer, respectively; and
the normally-closed device further comprises a body electrode connected to the second P-type nitride layer and the source electrode, respectively.

4. The normally-closed device according to claim 3, wherein a doping concentration of the second P-type nitride layer is variable in an epitaxial growth direction.

5. The normally-closed device according to claim 4, wherein the doping concentration of the second P-type nitride layer is decreased in the epitaxial growth direction.

6. The normally-closed device according to claim 4, wherein the doping concentration of the second P-type nitride layer is decreased first and then increased in the epitaxial growth direction.

7. The normally-closed device according to any one of claims 3 to 6, wherein the normally-closed device comprises a mounting region, the mounting region penetrates through the barrier layer and the modified layer located in the source electrode region, and the body electrode is provided in the mounting region.

8. The normally-closed device according to any one of claims 1 to 7, wherein the normally-closed device further comprises an insulating layer located between the gate electrode and the barrier layer.

9. The normally-closed device according to any one of claims 1 to 8, wherein the normally-closed device further comprises a channel layer, one side of the channel layer is connected to the first P-type nitride layer and the modified layer respectively, and the other side of the channel layer is connected to the barrier layer, the source electrode, and the drain electrode.

10. A fabrication method of a normally-closed device, comprising:
step 1, providing a substrate;
step 2, fabricating an epitaxial layer along a growth surface of the substrate, wherein the epitaxial layer comprises a first P-type nitride layer and a second P-type nitride layer, the second P-type nitride layer is located on two sides of the first P-type nitride layer, and the first P-type nitride layer and the second P-type nitride layer are located on a same plane;
step 3, modifying the second P-type nitride layer so as to form a modified layer on two sides of the first P-type nitride layer;
step 4, fabricating a barrier layer along a side of the first P-type nitride layer and a side of the modified layer, with the sides away from the substrate; and
step 5, fabricating a gate electrode, a source electrode, and a drain electrode.

11. The fabrication method according to claim 10, wherein the step of fabricating an epitaxial layer along a growth surface of the substrate in step 2 comprises:
growing a buffer layer along the growth surface of the substrate; and
growing the epitaxial layer on a surface of the buffer layer.

12. The fabrication method according to claim 10 or 11, wherein the step 3 comprises:
fabricating a mask along a surface of the first P-type nitride layer;
modifying the second P-type nitride layer by ion implantation, until the second P-type nitride layer is completely modified; and
removing the mask.

13. The fabrication method according to claim 12, wherein heat treatment is performed after the step of removing a mask.

14. The fabrication method according to claim 13, wherein a channel layer is epitaxially grown.

15. The fabrication method according to any one of claims 10 to 13, further comprising: forming an insulating layer between the gate electrode and the barrier layer.

16. The fabrication method according to claim 10 or 11, wherein the step 3 comprises:
fabricating a mask along a surface of the first P-type nitride layer;
partially modifying, by ion implantation, the second P-type nitride layer in a source electrode region and a region between the gate electrode and the source electrode ;
completely modifying, by ion implantation, the second P-type nitride layer located in a drain electrode region and a region between the gate electrode and the drain electrode, until the second P-type nitride layer located in the drain electrode region and the region between the gate electrode and the drain electrode is completely modified; and
removing the mask,
wherein after the step 5, the fabrication method further comprises: fabricating a body electrode, wherein the body electrode is connected to the second P-type nitride layer and the source electrode, respectively.

17. The fabrication method according to claim 16, prior to the step of modifying by ion implantation the second P-type nitride layer located in a drain electrode region and a region between the gate electrode and the drain electrode until the second P-type nitride layer located in the drain electrode region and the region between the gate electrode and the drain electrode is completely modified, further comprising:
removing the mask, and meanwhile fabricating a new mask so as to cover the gate electrode region, the region between the gate electrode and the source electrode, and the source electrode region.

18. The fabrication method according to claim 16 or 17, wherein different energies and doses are adopted in the partial modification and the complete modification respectively, to implant ions into the second P-type nitride layer.

19. The fabrication method according to claim 18, wherein the energy and the dose adopted for the ion implantation in the complete modification are greater than the energy and the dose adopted for the ion implantation in the partial modification.
